# EUROPÄISCHE PATENTSCHRIFT

(11) **EP 1 925 080 B1**
(45) Veröffentlichungstag und Bekanntmachung des Hinweises auf die Patenterteilung: **09.06.2010**
(21) Anmeldenummer: 06792867.1
(22) Anmeldetag: 17.08.2006
(51) Int. Cl.: H03K 17/955

(54) **KAPAZITIVER ANNÄHERUNGSSCHALTER UND HAUSHALTGERÄT MIT EINEM SOLCHEN**
CAPACITIVE PROXIMITY SWITCH AND HOUSEHOLD APPLIANCE EQUIPPED THEREWITH
DETECTEUR DE PROXIMITE CAPACITIF ET APPAREIL DOMESTIQUE COMPORTANT UN TEL DETECTEUR

(30) Priorität: 30.08.2005 DE 102005041112
(43) Veröffentlichungstag der Anmeldung: 28.05.2008
(73) Patentinhaber: BSH Bosch und Siemens Hausgeräte GmbH, 81739 München (DE)
(72) Erfinder: GROSSER, Jörg, 93077 Bad Abbach (DE); KLOPFER, Wilfried, 93057 Regensburg (DE); REINKER, Bernward, 93128 Regenstauf (DE); ROMANOWSKI, Hans-Jürgen, 93170 Bernhardswald (DE)
(86) Internationale Anmeldenummer: PCT/EP2006/065389
(87) Internationale Veröffentlichungsnummer: WO 2007/025866

(56) Entgegenhaltungen:
- WO-A1-00/52657
- US-A- 5 442 347
- US-A- 5 917 165

## Beschreibung

Die Erfindung bezieht sich auf einen kapazitiven Annäherungsschalter, mit einer von einer elektrisch isolierenden Abdeckplatte abgedeckten elektrisch leitenden Sensorfläche als Teil eines Kondensators mit durch Annäherung veränderlicher Kapazität.

Es sind bereits zahlreiche Vorrichtungen wie z.B. aus der WO 00/52657 mit kapazitiven Sensoren oder Schaltern bekannt. Die vorliegende Erfindung bezieht sich auf eine spezielle Bauart von kapazitiv wirkenden Schaltern, bei der eine elektrisch leitende Sensorfläche von einer elektrisch isolierenden Abdeckplatte abgedeckt ist. Ein Benutzer berührt also die Sensorfläche nicht direkt, sondern nähert sich ihr bei Berührung der Abdeckplatte lediglich an. Die Sensorfläche bildet eine Platte eines offenen Kondensators, dessen Kapazität von dem Abstand zu einer zweiten Platte (z.B. Erde) abhängt, der beispielsweise durch Annäherung eines Fingers des Benutzers verändert wird.

Ein solcher kapazitiver Annäherungsschalter ist bereits aus DE 695 19 701 T2 bekannt. Dort ist ein Halbleiterschalter vorgesehen, dessen Signaleingang mit einem Eingangssignal in Form einer Folge polarisierter Impulse versorgt wird und der im Ruhezustand, d.h. wenn der Annäherungsschalter nicht betätigt wird, in einem gesperrten Zustand ist, so dass an dem Signalausgang des Halbleiterschalters kein Ausgangssignal anliegt. Ein solcher Annäherungsschalter hat allerdings den Nachteil, dass eine Betätigung durch den Benutzer von einer Fehlbedienung beispielsweise durch Verschmutzungen der Abdeckplatte nicht eindeutig unterschieden werden kann.

Der vorliegenden Erfindung liegt daher die Aufgabe zugrunde, einen verbesserten, kostengünstigen kapazitiven Annäherungsschalter zur Verfügung zu stellen.

Gelöst wird die vorstehend aufgezeigte Aufgabe bei einem kapazitiven Annäherungsschalter der eingangs genannten Art erfindungsgemäß dadurch, dass die Sensorfläche eine aktive Abschirmung auf weist. Die aktive Abschirmung ist durch eine Abschirmfläche gebildet, an der zeitgleich mit der Sensorfläche ein Taktsignal anliegt. Werden die Sensorfläche und die benachbart zur Sensorfläche liegende Abschirmfläche zeitgleich mit einem möglichst identischen bzw. dem gleichen Taktsignal versorgt, so bringt dies den Vorteil mit sich, dass es zwischen der Sensorfläche und der Abschirmfläche zu keinem Potenzialunterschied, damit zu keiner Ladungsverschiebung und somit zu keiner kapazitiven Beeinflussung der Sensorfläche kommt. Dies ist insbesondere bei Kapazitäten des mit der Sensorfläche gebildeten Kondensators in der Größenordnung von Piko-Farad wichtig, da in diesem Bereich selbst kleine Störkapazitäten von beispielsweise Leitungen, benachbarten Sensorflächen oder Metallgehäusen eine Messung der Kapazität des Kondensators beeinflussen. Durch eine Minimierung des Einflusses dieser Störkapazitäten auf die Sensorfläche mit Hilfe der aktiven Abschirmung ist es möglich, den Annäherungsschalter in der Nähe von metallischen Gehäuseteilen anzuordnen, selbst wenn diese geerdet sind. Darüber hinaus ist es nun nicht mehr nötig die Sensorfläche in unmittelbarer Nähe zur Auswerteelektronik des Annäherungsschalters zu platzieren, um Störkapazitäten zu minimieren, sondern die Sensorfläche kann zusammen mit der Abschirmfläche entfernt von der Auswerteelektronik angeordnet werden. Hierdurch wird es möglich, die Sensorfläche und die Verbindungsleitungen in Form einer preisgünstigen kupferkaschierten Polyesterfolie auszuführen, die einen Anschluss zu der Auswerteelektronik aufweist.

Vorzugsweise liegt das Taktsignal über einen niederohmigen Widerstand an der Abschirmfläche an. Auf diese Weise kann die Signalform des Taktsignals an der Abschirmfläche an die Signalform des Taktsignals an der Sensorfläche angeglichen werden. Das Taktsignal, das insbesondere von einem Analogausgang eines Mikroprozessors ausgegeben wird, ist vorteilhafterweise ein periodisches Taktsignal, insbesondere ein Rechtecksignal und weist eine Frequenz bevorzugt im Bereich von 10 bis 100 Kilohertz auf. Dadurch ist eine ausreichende Abfragehäufigkeit der Kapazität des mit der Sensorfläche gebildeten Kondensators zur Detektion einer Betätigung des Annäherungsschalters gewährleistet. Darüber hinaus kann auf einen teuren, separaten Frequenzgenerator zur Erzeugung des Taktsignals verzichtet werden, wodurch sich die Anzahl der notwendigen Bauteile reduziert.

Gemäß einer bevorzugten Ausführungsform ist die Abschirmfläche zum Anlegen von Massepotenzial über einen Schalter mit Masse verbindbar. Wobei hier unter Masse ein festes Potenzial, wie beispielsweise Erdpotenzial oder ein Bezugspotenzial des Annäherungsschalters verstanden wird. Zur Funktionsprüfung des Annäherungsschalters, d.h. zur Ermittlung eines Referenzwertes des Ausgangssignals kann die Abschirmfläche durch den Schalter zeitweise mit Masse verbunden werden, wodurch die aktive Abschirmung zeitweise außer Kraft gesetzt und eine Betätigung des Annäherungsschalters simuliert wird. Auf diese Weise kann überprüft werden, ob ein ausreichender Signalhub des Ausgangssignals bei Betätigung des Annäherungsschalters vorliegt, oder ob eventuell aufgrund von Verunreinigungen oder Benetzung der Abdeckplatte oder aufgrund von Alterungsprozessen des Annäherungsschalters eine Fehlfunktion vorliegt. Auf diese Weise können Fehlbedienungen des Annäherungsschalters vermieden werden, wodurch die Funktionssicherheit des Annäherungsschalters verbessert wird. Insbesondere kann ein mit dem erfindungsgemäßen Annäherungsschalter ausgestattetes Gerät automatisch abgeschaltet werden, wenn eine sichere Funktion des Annäherungsschalters nicht mehr gewährleistet ist. Eventuell kann der Signalhub des Ausgangssignals durch Änderung der Höhe des Taktsignals dynamisch angepasst werden, d.h. der Annäherungsschalter kann automatisch kalibriert werden.

Vorteilhafterweise weist der Schalter einen Steuersignaleingang auf, der mit einem Steuersignalausgang eines Mikroprozessors verbunden ist. Insbesondere ist der Schalter ein Transistor, wie z.B. ein PNP- oder ein NPN-Bipolartransistor, dessen Basis mit dem Steuersignalausgang des Mikroprozessors verbunden ist. Somit kann der Schalter bzw. Transistor auf einfache Weise per Software-Programm über den Mikroprozessor geschaltet werden, so dass eine automatische Funktionsprüfung des Annäherungsschalters zu vorgegebenen Zeitpunkten möglich ist.

Je nach Anwendungsfall können die Abschirmfläche und die Sensorflächen unterschiedlich angeordnet werden. Beispielsweise sind die Abschirmfläche und die Sensorfläche auf die Rückseite der Abdeckplatte aufgebracht, wobei die Abschirmfläche die Sensorfläche umgibt. Insbesondere können die Abschirmfläche und die Sensorfläche auf die Rückseite der Abdeckplatte aufgedampft oder aufgeklebt oder aufgedruckt sein. Alternativ dazu sind die Abschirmfläche und die Sensorfläche auf der gleichen Seite eines Trägers angeordnet, wobei die Abschirmfläche die Sensorfläche ebenfalls umgibt.

In einer weiteren Ausführungsform ist die Sensorfläche auf der Vorderseite eines Trägers und die Abschirmfläche auf der Rückseite des Trägers zumindest im Bereich der Sensorfläche angeordnet. Auf diese Weise kann die Sensorfläche gegenüber rückwärtig angeordneter Leistungselektronik abgeschirmt werden, insbesondere bei einem Haushaltgerät, wie beispielsweise einer Waschmaschine, einem Wäschetrockner, einer Geschirrspülmaschine, einem Gargerät, einer Dunstabzugshaube, einem Kältegerät, einem Klimagerät, einem Warmwasserbereiter oder einem Staubsauger. Insbesondere ist der Träger eine Leiterplatte, die einen Teilbereich der Vorderseite als Sensorfläche aufweist und deren gesamte Rückseite als Abschirmfläche ausgebildet ist.

Gemäß einer bevorzugten Ausführungsform ist der Träger in einem Abstand von der Abdeckplatte angeordnet, und zwischen Abdeckplatte und Träger ist ein elektrisch leitfähiger Körper angeordnet, der den Abstand überbrückt und der mit der Sensorfläche elektrisch leitend verbunden ist und/oder der zumindest mit einem Teil seiner Oberfläche zumindest einen Teil der Sensorfläche bildet. Durch den elektrisch leitfähigen Körper wird die sensorische Fühlereigenschaft der Sensorfläche von dem Träger an die Rückseite der Abdeckplatte verlagert. Die Abschirmfläche ist durch die Luftschicht zwischen Träger und Abdeckplatte gegenüber Ladungsänderungen an der Vorderseite der Abdeckplatte, insbesondere bei Berührung durch einen Benutzer, isoliert.

In einer anderen Ausführungsform ist der Träger eine flexible Leiterplatte oder eine kupferkaschierte Kunststofffolie. Solch ein Träger kann an Abdeckplatten verschiedenster Krümmungen angepasst werden, so dass die Sensorfläche formschlüssig an der Rückseite der Abdeckplatte anliegt. Insbesondere kann solch ein Träger an die Rückseite der Abdeckplatte angedrückt oder angeklebt werden.

In der bevorzugten Ausführungsform, bei der der Träger in einem Abstand von der Abdeckplatte und zwischen Abdeckplatte und Träger ein elektrisch leitfähiger Körper angeordnet ist, der den Abstand überbrückt und der mit der Sensorfläche elektrisch leitend verbunden ist und/oder der zumindest mit einem Teil seiner Oberfläche zumindest einen Teil der Sensorfläche bildet, hat es sich als besonders günstig erwiesen, auf dem Träger zumindest ein elektronisches Bauelement derart anzuordnen, dass es in einen Hohlraum ragt, der von dem elektrisch leitfähigen Körper umgeben ist. Insbesondere zusammen mit einer auf der Rückseite der Leiterplatte angeordneten Abschirmfläche bildet der elektrisch leitfähige Körper, der insbesondere eine aus einem gestreckten Körper gewundene Druckfeder ist, eine Art Faradaykäfig für das elektronische Bauelement, so dass dieses gegenüber elektromagnetischen Störsignalen der Umgebung abgeschirmt ist. Bevorzugt wird auf diese Weise der Halbleiterschalter auf dem Träger angeordnet und von elektromagnetischen Störsignalen abgeschirmt, so dass die Qualität des Ausgangssignals verbessert ist.

Vorteilhafterweise ist auf dem Träger in den von dem elektrisch leitfähigen Körper umgebenen Hohlraum ragend und/oder innerhalb eines durch die Sensorfläche definierten Bereichs ein Leuchtelement angeordnet, wie beispielsweise eine LED, eine Glühlampe oder ein Lichtleiter. Dieses Leuchtelement kann zur Kennzeichnung der Sensorfläche oder zur Signalisierung verschiedener Schaltzustände des Annäherungsschalters dienen. Weiterhin kann zur Positionskennzeichnung der Sensorfläche an der Oberseite der Abdeckplatte oder bei durchsichtiger Abdeckplatte an deren Unterseite eine Markierung, z.B. in Form eines Aufdrucks angebracht sein.

Vorzugsweise ist ein Haushaltgerät, wie beispielsweise eine Waschmaschine, ein Wäschetrockner, eine Geschirrspülmaschine, ein Gargerät, eine Dunstabzugshaube, ein Kältegerät, ein Klimagerät, ein Warmwasserbereiter oder ein Staubsauger, bzw. ein Eingabefeld für ein Haushaltgerät mit zumindest einem erfindungsgemäßen Annäherungsschalter ausgestattet. Somit kann das Haushaltgerät mit einer das Eingabefeld umfassenden durchgängige Blende ausgestattet werden, so dass das Haushaltgerät gegenüber einem Eintritt von Verschmutzungen oder Feuchtigkeit geschützt ist. Die Blende entspricht dabei der elektrisch isolierenden Abdeckplatte und kann beispielsweise aus Glas, Glaskeramik, Keramik, Kunststoff, Holz oder Stein gefertigt sein. Des weiteren ist durch den erfindungsgemäßen Annäherungsschalter die Gerätesicherheit gewährleistet, da das Haushaltgerät automatisch abgeschaltet wird, wenn die Funktionsfähigkeit des Annäherungsschalters nicht mehr gegeben ist.

Gemäß einer bevorzugten Ausführungsform weist das Eingabefeld mehrere Sensorflächen auf, die in einer Matrixform zum Betreiben in einem Multiplexverfahren geschaltet sind. Durch die hohe Frequenz des Taktsignals ist eine ausreichende Abfragehäufigkeit der Kapazitäten der mit den Sensorflächen gebildeten Kondensatoren zur Bestimmung einer Betätigung durch einen Benutzer gewährleistet. Die Verwendung von nur einem Taktsignal hat den Vorteil, dass nur ein Taktsignalgeber nötig ist.

In einer weiteren Ausführungsform sind zumindest zwei Sensorflächen, insbesondere auf der Rückseite der Abdeckplatte oder auf einem gemeinsamen Träger, benachbart angeordnet und bilden zusammen einen Positionssensor. Je nachdem an welcher Position relativ zu den Sensorflächen eine Betätigung durch den Benutzer aufgrund der den Sensorflächen zugehörigen Ausgangssignale detektiert wird, können unterschiedliche Schaltzustände ausgelöst werden. Auf diese Weise kann ein Schiebeschalter ohne mechanisch zu verschiebende Elemente gebildet werden, indem der Benutzer beispielsweise mit einem Finger über einen dem Positionssensor zugeordneten Bereich der Abdeckplatte bzw. der Blende streicht.

Es wird darauf hingewiesen, dass die Merkmale der Unteransprüche ohne Abweichung von der erfindungsgemäßen Idee in beliebiger Weise miteinander kombinierbar sind.

Anhand von Zeichnungen wird die Erfindung nachstehend näher erläutert.
- Fig. 1: zeigt in einer schematischen Schnittansicht einen Ausschnitt eines Haus- haltgerätes mit einer Blende, die ein erfindungsgemäßes Eingabefeld aufweist,
- Fig. 2: zeigt in einer schematischen Vorderansicht eine Ausführungsform einer Sensorfläche mit einer die Sensorfläche umrahmenden Abschirmfläche,
- Fig. 3a, 3b: zeigen schematisch einen Ausschnitt des Eingabefeldes gemäß Figur 1 mit einer Betätigung eines erfindungsgemäßen kapazitiven Annäherungs- sensors durch einen Benutzer,
- Fig. 4: zeigt einen Ausschnitt eines schematischen elektrischen Schaltkreises des erfindungsgemäßen kapazitiven Annäherungsschalters,
- Fig. 5: zeigt einen Ausschnitt eines schematischen elektrischen Schaltkreises des erfindungsgemäßen Annäherungsschalters mit einer aktiven Ab- schirmung,
- Fig. 6: zeigt einen schematischen Schaltkreis des Eingabefeldes gemäß Fig. 1 mit mehreren in einer Matrixform verschalteten erfindungsgemäßen An- näherungsschalter,
- Fig. 7: zeigt in einer schematischen Vorderansicht eine Ausführungsform zweier Sensorflächen, die einen Positionssensor bilden,
- Fig. 8: zeigt in einer schematischen Schnittansicht einen Ausschnitt des Einga- befeldes gemäß Figur 1 mit elektronischen Bauelementen des elektri- schen Schaltkreises gemäß Figur 4, die in einen von einer Druckfeder umgeben Hohlraum ragen.

Bevor auf die Zeichnungen näher eingegangen wird, sei angemerkt, dass einander entsprechende oder gleiche Elemente bzw. Einzelteile bei den verschiedenen Ausführungsformen des kapazitiven Annäherungsschalters gemäß der Erfindung in sämtlichen Zeichnungsfiguren durch gleiche Bezugszeichen bezeichnet sind. Werden in einer Zeichnung mehrere Elemente bzw. Einzelteile gleicher Art verwendet, auf die unterschiedlich Bezug genommen wird, so wird für die führende(n) Stelle(n) der entsprechenden Bezugszeichen jeweils die gleiche(n) Ziffer(n) gewählt. Die folgenden Stellen der entsprechenden Bezugszeichen dienen dazu, die Elemente bzw. Einzelteile gleicher Art zu unterscheiden.

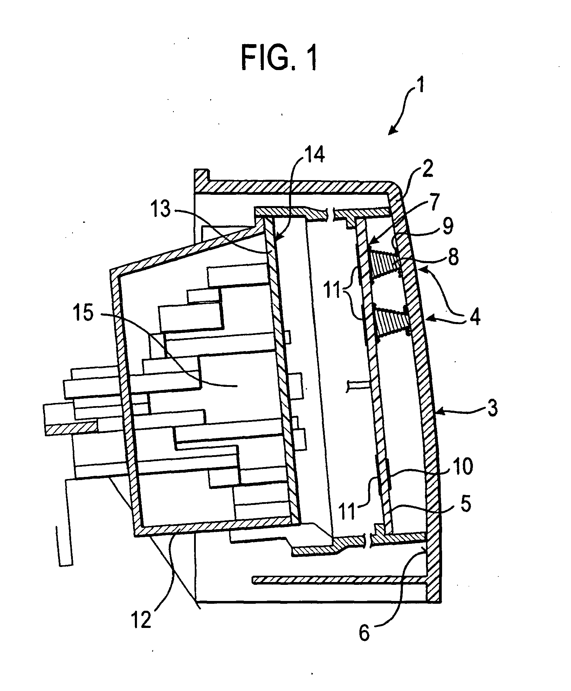

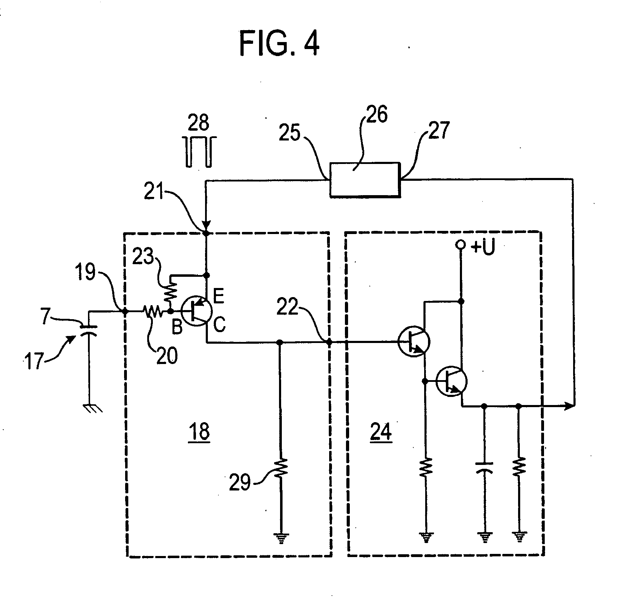

In Fig. 1 ist in einer schematischen Schnittansicht ein Ausschnitt eines Haushaltgerätes 1 mit einer Blende 2 gezeigt, die ein erfindungsgemäßes Eingabefeld 3 aufweist. Die Blende 2 ist als elektrisch isolierende Abdeckplatte aus einem Dielektrikum, wie beispielsweise Glas, Glaskeramik, Keramik, Kunststoff, Holz oder Stein ausgebildet. Das Eingabefeld 3 enthält mehrere baugleiche kapazitive Annäherungsschalter 4, von denen hier nur zwei gezeigt sind und von denen im folgenden lediglich einer beschrieben wird. In einem Abstand von der Blende 2 ist eine Leiterplatte 5 mit einer der Rückseite 6 der Blende 2 zugewandten elektrisch leitfähigen Sensorfläche 7 angeordnet. Die Leiterplatte 5 kann eine Kunststoffplatte sein, die auf wenigstens einer ihrer Plattenseiten die erwähnte Sensorfläche 7 und gegebenenfalls Leiterbahnen aufweist, über die die Sensorfläche 7 mit einem elektrischen Schaltkreis 14 des Annäherungsschalters 4 (siehe Fig. 4, 5 und 6) elektrisch leitend verbunden ist. Die elektrisch leitende Schicht der Sensorflächen 7 kann in verschiedenen Formen ausgebildet sein, beispielsweise rund oder eckig, vollflächig, gitterförmig oder rahmenförmig.

Zwischen der Blende 2 und der Leiterplatte 5 ist ein elektrisch leitfähiger Körper in Form einer gewundene Druckfeder 8 angeordnet, die vorzugsweise aus Federdraht ausgebildet ist. Die Druckfeder 8 weist an ihrem oberen Ende einen flachen Windungsteller 9 auf, der aus mehrere Windungen besteht, die aufgrund einer Druckspannung, unter der die Druckfeder 8 steht, spiralförmig ineinander liegen und formschlüssig an die leicht gewölbte Form der Rückseite 6 der Blende 2 angepasst sind. Die Druckfeder 8 weist an ihrem unteren Ende eine untere Windung 9' auf, mit der sie an der Sensorfläche 7 der Leiterplatte 5 plan anliegt und dort mit der Sensorfläche 7 der Leiterplatte 5 beispielsweise verlötet oder verklebt ist, oder mit der sie an der Sensorfläche 7 der Leiterplatte 5 lediglich unter Druckspannung fest anliegt, so dass eine elektrisch leitende Verbindung zwischen der Druckfeder 8 und der Sensorfläche 7 der Leiterplatte besteht. Durch diese elektrisch leitende Verbindung ist die sensorische Fühlereigenschaft der Sensorfläche 7 von der Leiterplatte 5 an die Rückseite 6 der Blende 2 verlagert und die Druckfeder 8 bildet nun ihrerseits zumindest einen Teil der Sensorfläche 7, insbesondere mit ihrem Windungsteller 9, 9'. Anstatt als gewundene, metallische Druckfeder 8 kann der elektrisch leitfähige Körper auch andere Formen aufweisen, wie beispielsweise zylinder- , kegel- oder quaderförmig, und/oder aus anderen, elektrisch leitfähigen Materialien ausgebildet sein, wie beispielsweise aus einem elektrisch leitfähigen Kunststoff oder aus einem Kunststoff mit metallischer Seele.

Auf der gleichen Seite der Leiterplatte 5, auf der sich die Sensorfläche 7 befindet, also auf der der Rückseite 6 der Blende 2 zugewandten Vorderseite der Leiterplatte 5, ist eine elektrisch leitfähigen Referenzsensorfläche 10 angeordnet. Die Referenzsensorfläche 10 ist analog zu der Sensorfläche 7 mit dem Schaltkreis 14 des Annäherungsschalters 4 elektrisch leitend verbunden. Es kann für jede der Sensorflächen 7 eine zugehörige Referenzsensorfläche 10 oder für mehrere oder alle der Sensorflächen 7 eine gemeinsame Referenzsensorfläche 10 vorgesehen sein. Im Unterschied zu der Sensorfläche 7 fehlt bei der Referenzsensorfläche 10 die elektrisch leitfähige Druckfeder 8, so dass die Referenzsensorfläche 10 durch die Luftschicht zwischen der Leiterplatte 5 und der Blende 2 gegenüber elektrischen Ladungen bzw. Ladungsänderungen an der Vorderseite der Blende 2 elektrisch isoliert ist.

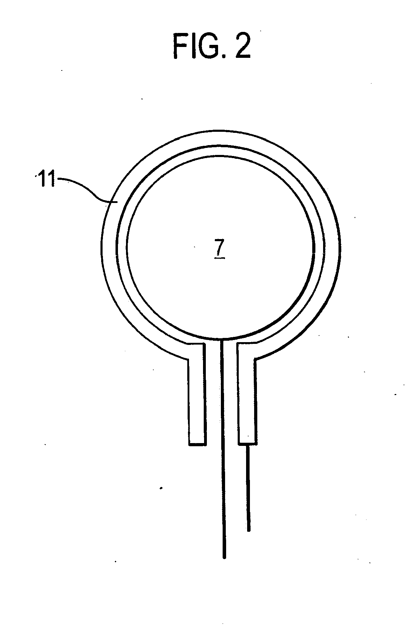

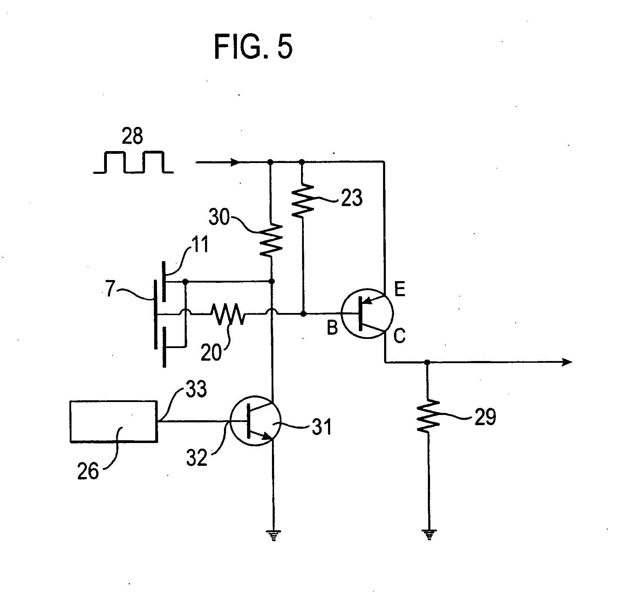

Auf der Rückseite der Leiterplatte 5 ist an der Position der Sensorfläche 7 bzw. der Referenzsensorfläche 10 jeweils eine elektrisch leitende Abschirmfläche 11 angeordnet, deren Funktionsweise weiter unten in Figur 5 beschrieben wird. Anstelle von einzelnen Abschirmflächen 11 je Sensorfläche 7 bzw. Referenzsensorfläche 10 kann eine einzige Abschirmfläche vorgesehen sein, die sich über die gesamte Rückseite der Leiterplatte 5 erstreckt oder die zumindest auf der Rückseite der Leiterplatte 5 den Bereich abdeckt, der die Sensorflächen 7 bzw. die Referenzsensorfläche 10 umfasst. Insbesondere kann die Leiterplatte 5 eine flexible Leiterplatte oder eine kupferkaschierte Kunststofffolie sein. In einer weiteren alternative Ausführungsform, die in Figur 2 gezeigt ist, befinden sich die Sensorfläche 7, die hier rund ausgeführt ist, und die Abschirmfläche 11 beide auf der Vorderseite der Leiterplatte 5. Die Abschirmfläche 11 wird hier durch einen elektrisch leitfähige Schicht gebildet, die die Sensorfläche 7 rahmenförmig umgibt, wobei die Form dieses Rahmens der Außenkontur der Sensorfläche 7 angepasst ist.

Der elektrische Schaltkreis 14 des Annäherungsschalters 4 kann auf der Vorder- oder Rückseite der Leiterplatte 5 oder auf einer separaten Platine angeordnet sein. Des weiteren kann für mehrere oder alle Annäherungsschalter 4 ein gemeinsamer Schaltkreis 14 vorgesehen sein. In der in Figur 1 gezeigten Ausführungsform ist im rückwärtigen Bereich der Leiterplatte 5 ein Elektronikmodul 12 angeordnet, das eine Platine 13 aufweist, die auf ihrer der Leiterplatte 5 zugewandten Vorderseite den Schaltkreis 14 des Annäherungsschalters 4 aufweist und die auf ihrer Rückseite mit Leistungselektronik 15 des Haushaltgerätes 1 bestückt ist. Diese Platine 13 ist mit der Leiterplatte 5 elektrisch leitend verbunden (nicht gezeigt).

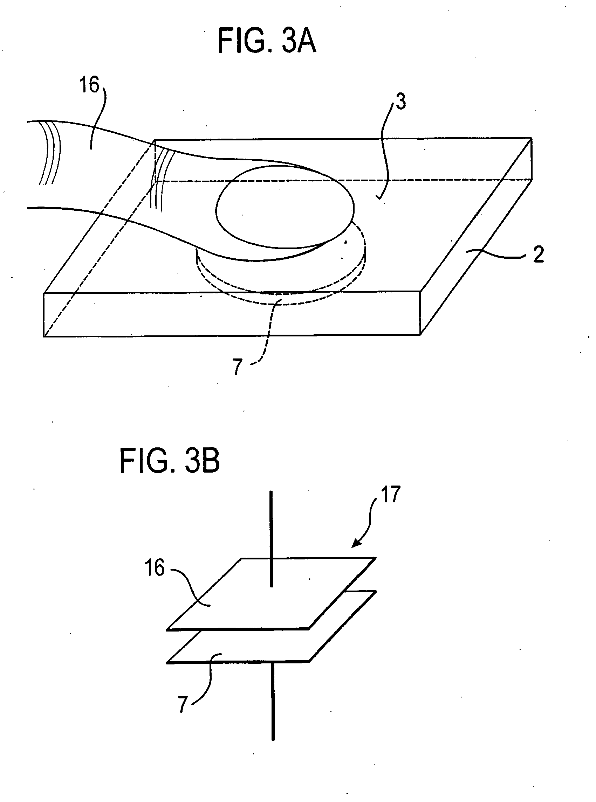

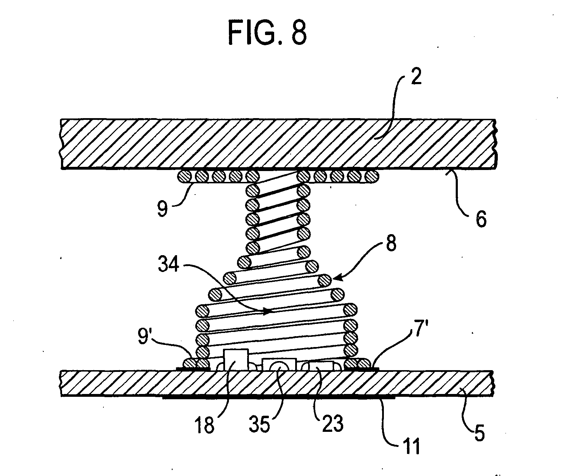

Wird nun wie in Figur 3a gezeigt ein Element, wie beispielsweise ein Finger 16 eines Benutzers, das bzw. der ein vom Potenzial der Sensorflächen 7 verschiedenes Potenzial, insbesondere Erdpotenzial führt, an einen der Sensorfläche 7 gegenüberliegenden Oberflächenbereich der Blende 2 angenähert und/oder mit diesem in Berührung gebracht, so wird dadurch eine Kapazitätsänderung eines aus dem betreffenden Element bzw. dem Finger 16, der Blende 2 und der Sensorfläche 7 bzw. der Sensorfläche 7 zusammen mit der Druckfeder 8 bestehenden Kondensators 17 hervorgerufen (vgl. Fig. 3b). Da die Sensorfläche 7 elektrisch leitend mit dem Schaltkreis 14 des Annäherungsschalters 4 verbunden ist, kann die Kapazitätsänderung durch den Schaltkreis 14 festgestellt und zur Auslösung eines Schaltsignals weiter ausgewertet werden, wie weiter unten beschrieben. Des weiteren kann auf der Leiterplatte 5 im Bereich innerhalb der Druckfeder 8 eine Lichtquelle 35 (vgl. Fig. 8), wie beispielsweise eine LED, vorgesehen sein, um die Sensorfläche 7 zu kennzeichnen oder unterschiedliche Schaltzustände des Annäherungsschalters 4 zu signalisieren.

In Figur 4 ist ein Ausschnitt eines Schaltbildes des elektrischen Schaltkreises 14 gezeigt. Der Schaltkreis 14 weist als Halbleiterschalter 18 einen PNP-Bipolartransistor auf, mit dessen Steuereingang 19, also mit dessen Basis, die Sensorfläche 7 über einen Strombegrenzungswiderstand 20 verbunden ist. Der Halbleiterschalter 18 weist darüber hinaus einen Signaleingang 21, d.h. den Emitter des PNP-Bipolartransistors, und einen Signalausgang 22, d.h. den Kollektor des PNP-Bipolartransistors, auf, wobei der Signaleingang 21 über einen Basis-Emitter-Widerstand 23 mit der Sensorfläche 7 verbunden ist. Der Strombegrenzungswiderstand 20 und der Basis-Emitter-Widerstand 23 können in dem PNP-Bipolartransistor bereits integriert ausgeführt sein. Der Signalausgang 22 des Halbleiterschalters 18 ist zur weiteren Verarbeitung eines Ausgangssignals mit einer Sample and Hold-Stufe 24 bekannter Art verbunden, durch die ein Gleichspannungssignal proportional zur Amplitude der Impulsspitzen des Ausgangssignals zur Verfügung gestellt werden kann und die hier nicht weiter beschrieben wird. Alternativ zu der Sample and Hold-Stufe 24 kann der Signalausgang 22 des Halbleiterschalters 18 zur Verarbeitung des Ausgangssignals mit einer bekannten Integratorschaltung oder einem bekannten Spitzenspannungsmesser verbunden sein (nicht gezeigt). Der Signaleingang 21 des Halbleiterschalters 18 ist mit einem analogen Signalausgang 25 eines Mikroprozessors 26 und der Signalausgang 22 des Halbleiterschalters 18 ist über die Sample and Hold-Stufe 24 mit einem analogen Signaleingang 27 des Mikroprozessors 26 verbunden. Anstelle des einen Mikroprozessors 26 können auch zwei verschiedene Mikroprozessoren verwendet werden, von denen einer mit dem Signaleingang 21 des Halbleiterschalters 18 und der andere mit dem Signalausgang 22 des Halbleiterschalters 18 verbunden ist. Anstelle des PNP-Bipolartransistors können auch andere Halbleiterschalter 18 verwendet werden, wie beispielsweise ein NPN-Bipolartransistor, Feldeffekttransistoren oder allgemein alle steuerbaren Halbleiterelemente.

An dem Signaleingang 21 des Halbleiterschalters 18 liegt ein Taktsignal 28 an, welches beispielsweise von dem analogen Signalausgang 25 des Mikroprozessors 26 zur Verfügung gestellt wird. Das Taktsignal 28 ist ein rechteckförmiges, periodisches Spannungssignal, welches von dem Mikroprozessor 26 regelmäßig zwischen Massepotenzial, d.h. LOW-Pegel, und Betriebsspannung des Schaltkreises 14 des Annäherungsschalters 4, d.h. HIGH-Pegel, umgeschaltet wird, wobei das Massepotenzial von dem Erdpotenzial des Benutzers verschieden sein kann. Die Taktfrequenz des Taktsignals 28 liegt bevorzugt im Bereich zwischen 10 und 100 Kilohertz. Der Signalausgang 22 des Halbleiterschalters 18, also der Kollektor des PNP-Bipolartransistors, liegt über einen weiteren Widerstand 29 auf dem Bezugspotenzial der Sample and Hold-Stufe 24. Mit dem LOW-Pegel des Taktsignals 28 wird der Signaleingang 21 des Halbleiterschalters 18 und damit der Emitter E des PNP-Bipolartransistors sowie der Basis-Emitter-Widerstand 23 auf Massepotenzial gelegt. Dies führt dazu, dass die Sensorfläche 7 bzw. der Kondensator 17 über den Strombegrenzungswiderstand 20 und den Basis-Emitter-Widerstand 23 entladen wird. Dadurch wird die Basis B des PNP-Bipolartransistors gegenüber dem Emitter E des PNP-Bipolartransistors positiv und der PNP-Bipolartransistors sperrt. Mit dem auf den LOW-Pegel folgenden HIGH-Pegel des Taktsignals 28 wird die Sensorfläche 7 und damit der Kondensator 17 über den Basis-Emitterwiderstand 23 und den Strombegrenzungswiderstand 20 aufgeladen. Während dieser Aufladezeit der Sensorfläche 7 bzw. des Kondensators 17 besteht ein Spannungsabfall an dem Basis-Emitter-Widerstand 23. Dadurch wird die Basis B des PNP-Bipolartransistors gegenüber dem Emitter E negativ und der PNP-Bipolartransistor wird leitend und schaltet so lange durch, bis die Sensorfläche 7 bzw. der Kondensator 17 auf den HIGH-Pegel des Taktsignals 28 aufgeladen ist. An dem Widerstand 29 liegt während dieses Aufladezeitraums der Sensorfläche 7 bzw. des Kondensators 17 durch das Taktsignal 28 ein Ausgangssignal an, das proportional zu der Kapazität der Sensorfläche 7 bzw. des Kondensators 17 ist. Somit liegt an dem Signalausgang 22 des Halbleiterschalters 18 ein Ausgangsignal an, welches dem Taktsignal 28 folgt, und dessen Signalanteile proportional zu der Kapazität der Sensorfläche 7 bzw. des Kondensators 17 sind.

Dieses Ausgangssignal wird mittels der Sample and Hold-Stufe in ein Gleichspannungssignal umgewandelt und liegt an dem analogen Signaleingang 27 des Mikroprozessors 26 an. Der Mikroprozessor 26 ist zur Auswertung einer zeitlichen Änderung von Signalanteilen des Gleichspannungssignals und damit des Ausgangssignals beispielsweise mit Hilfe eines Software-Programms ausgebildet. Abhängig davon, wie schnell die Signalanteile des Ausgangssignals, wie beispielsweise die Höhe der Impulsspitze oder die Impulsbreite, von aufeinander folgenden Taktperioden sich ändern, wird von dem Mikroprozessor 26 eine Betätigung des Annäherungsschalters 4 erkannt. D.h. ändern sich die Signalanteile innerhalb eines vorgegebenen Zeitraums von beispielsweise einer Sekunde, so wird dies als Betätigung erkannt, ändern sich die Signalanteile langsamer, so liegt keine Betätigung vor. Auf diese Weise ist die Bestimmung einer Betätigung des Annäherungsschalters 4 unabhängig von der absoluten Größe des Ausgangssignals, wodurch dessen langfristige Änderungen, z.B. durch Alterungsprozesse, eliminiert sind.

In Figur 5 ist ein Ausschnitt des elektrischen Schaltkreises 14 des erfindungsgemäßen Annäherungsschalters 4 mit einer aktiven Abschirmung gezeigt. Die aktive Abschirmung ist durch die Abschirmfläche 11 gebildet, die über einen niederohmigen Widerstand 30 mit dem Signaleingang 21 des Halbleiterschalters 18 verbunden ist, und an der zeitgleich zu der Sensorfläche 7 das Taktsignal 28 über diesen niederohmigen Widerstand 30 anliegt. Durch geeignete Wahl des niederohmigen Widerstands 30 kann die Signalform des Taktsignals 28 an der Abschirmfläche 11 an die Signalform des Taktsignals 28 an der Sensorfläche 7 angeglichen werden, so dass kein Potenzialunterschied und damit keine Verschiebung von Ladungsträgern zwischen der Abschirmfläche 11 und der Sensorfläche 7 auftritt und somit die Abschirmung der Sensorfläche 7 durch die Abschirmfläche 11 gegenüber Störkapazitäten gewährleistet ist.

Die Abschirmfläche 11 ist zum Anlegen von Massepotenzial über einen Schalter 31, der in der hier gezeigten Ausführungsform ein NPN-Bipolartransistor ist, mit Masse verbunden. Der Schalter 31 weist einen Steuersignaleingang 32 auf, nämlich die Basis des NPN-Bipolartransistors, der mit einem Steuersignalausgang 33 des Mikroprozessors 26 verbunden ist. Somit kann der Schalter 31 bzw. der NPN-Bipolartransistor auf einfache Weise durch ein Software-Programm des Mikroprozessors 26 geschaltet werden. Zur Funktionsprüfung des Annäherungsschalters 4, d.h. zur Ermittlung eines Referenzwertes des Ausgangssignals wird die Abschirmfläche 11 durch den Schalter 31 zeitweise mit Massepotenzial verbunden, wodurch die aktive Abschirmung zeitweise außer Kraft gesetzt und eine Betätigung des Annäherungsschalters 4 simuliert wird. Auf diese Weise kann überprüft werden, ob ein ausreichender Signalhub des Ausgangssignals bei Betätigung des Annäherungsschalters 4 vorliegt, oder ob eventuell aufgrund von Verunreinigungen oder Benetzung der Blende 2, aufgrund von Umgebungsbedingungen, wie Temperatur und Feuchtigkeit, oder aufgrund von Alterungsprozessen des Annäherungsschalters 4 eine Fehlfunktion vorliegt. Eventuell kann der Signalhub des Ausgangssignals durch Änderung der Höhe des Taktsignals 28 dynamisch angepasst werden, d.h. der Annäherungsschalter 4 kann automatisch kalibriert werden, wodurch die Funktionssicherheit des Annäherungsschalters 4 verbessert wird. Wenn aufgrund beispielsweise einer verschmutzten Blende 2 eine sichere Funktion des Annäherungsschalters nicht mehr gewährleistet ist, wird das Haushaltgerät 1 automatisch abgeschaltet.

Die Referenzsensorfläche 10 ist entsprechend der Sensorfläche 7 verschaltet. Die Referenzsensorfläche 10 ist benachbart zu der Sensorfläche 7 angeordnet, so dass die Kapazität der Referenzsensorfläche 10 bzw. eines mit der Referenzsensorfläche 10 gebildeten offenen Referenzkondensators ein Maß für die Umgebungsbedingungen, d.h. die Störkapazitäten, der Sensorfläche 7, aber auch ein Maß für den Einfluss von Temperatur, Feuchtigkeit oder von Materialveränderungen durch Alterung auf das Ausgangssignal ist. An der Referenzsensorfläche 10 liegt das gleiche Taktsignal 28 wie an der Sensorfläche 7 an, insbesondere in einem zeitlichen Multiplexverfahren. D.h. die Sensorfläche 7 und die Referenzsensorfläche 10 werden nacheinander mit verschiedene Perioden des gleichen Taktsignals 28 versorgt. Alternativ dazu kann an die Referenzsensorfläche 10 auch ein weiteres Taktsignal von einem weiteren analogen Signalausgang des Mikroprozessors 26 angelegt werden. Das von der Referenzsensorfläche 10 erzeugte Referenzsignal wird bei der Auswertung des von der Sensorfläche 7 erzeugten Ausgangssignals in dem Mikroprozessor 26 als Grundpegel des Ausgangssignals berücksichtigt, und dient somit der Bestimmung eines Betätigungszustands des Annäherungsschalters 4. Bei Haushaltgeräten 1, die mit einem Netzschalter eingeschaltet werden, wird mit Hilfe des Referenzsignal bereits beim Einschalten festgestellt, ob eine Betätigung des Annäherungsschalters 4 vorliegt.

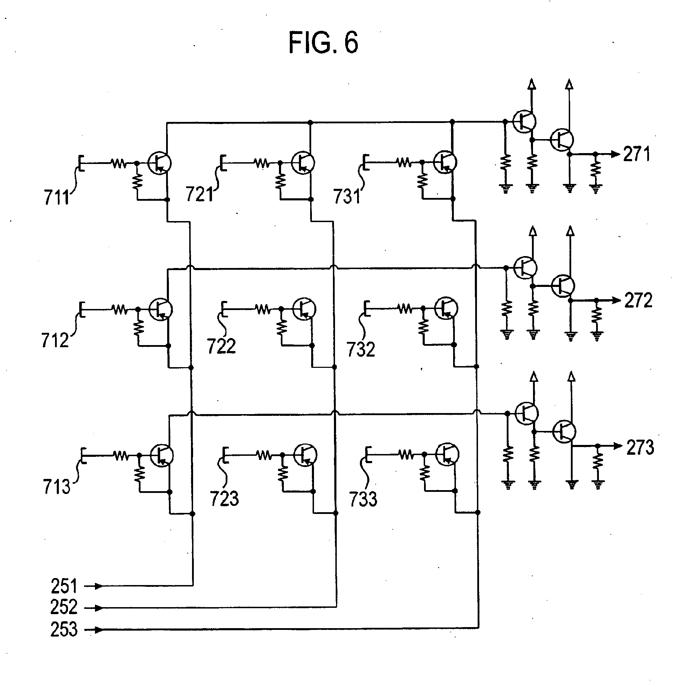

In Figur 6 ist ein schematischer Schaltkreis 14 des Eingabefeldes 3 mit neun in einer dreimal-drei-Matrixform geschalteten erfindungsgemäßen Annäherungsschalter 4 zum Betreiben in einem zeitlichen Multiplexverfahren gezeigt. Die Sensorflächen 711, 712, 713 der ersten drei Annäherungsschalter sind mit einem ersten Signalausgang 251 des Mikroprozessors 26 verbunden. Die Sensorflächen 721, 722 und 723 der zweiten drei Annäherungsschalter sind mit einem zweiten Signalausgang 252 des Mikroprozessors 26 verbunden. Die Sensorflächen 731, 732 und 733 der dritten drei Annäherungsschalter sind mit einem dritten Signalausgang 253 des Mikroprozessors 26 verbunden. Die Sensorflächen 711, 721 und 731 sind über ihren jeweils zugehörigen Halbleiterschalter und eine erste Sample and Hold-Stufe mit einem ersten Signaleingang 271 des Mikroprozessors 26 verbunden. Die Sensorflächen 712, 722 und 732 sind über ihren jeweils zugehörigen Halbleiterschalter und eine zweite Sample and Hold-Stufe mit einem zweiten Signaleingang 272 des Mikroprozessors 26 verbunden. Die Sensorflächen 713, 723 und 733 sind über ihren jeweils zugehörigen Halbleiterschalter und eine dritte Sample and Hold-Stufe mit einem dritten Signaleingang 273 des Mikroprozessors 26 verbunden.

Das Taktsignal 28 wird jeweils für eine vorgegebene Zeitdauer, d.h. für eine vorgegebene Anzahl an Taktperioden, von einem der drei Signalausgängen 251, 252 und 253 des Mikroprozessors 26 ausgegeben. Dabei wechseln sich die Signalausgänge 251, 252 und 253 nacheinander ab, was zyklisch wiederholt wird. In der Zeitdauer, in der das Taktsignal 28 von einem der drei Signalausgänge 251, 252 und 253 ausgegeben wird, werden jeweils alle drei Signaleingänge 271, 272 und 273 des Mikroprozessors 26 ausgewertet. Auf diese Weise können mit nur einem Schaltkreis nacheinander alle neun Sensorflächen 711, 712, 713, 721, 722, 723 731, 732 und 733 dahingehend überprüft werden, ob eine Betätigung des entsprechenden Annäherungsschalters durch einen Benutzer vorliegt.

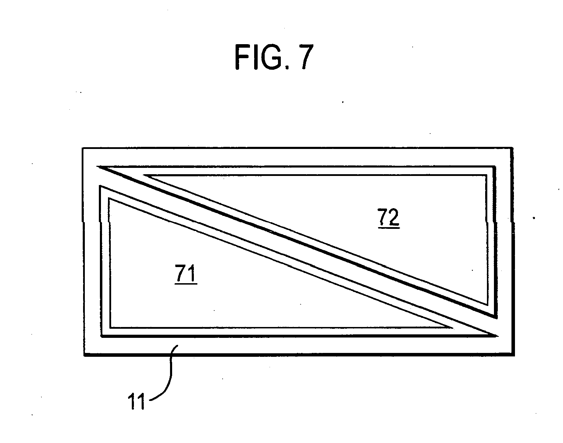

In Figur 7 ist in einer schematischen Vorderansicht eine Ausführungsform zweier Sensorflächen 71 und 72 gezeigt, die zusammen einen Positionssensor bilden. Die Sensorflächen 71 und 72 sind in Form rechtwinkliger Dreiecke ausgebildet und benachbart auf einem gemeinsamen Träger 5 oder auf der Rückseite der Blende 2 angeordnet, wobei sich die Sensorflächen 71 und 72 mit ihrer jeweiligen Hypotenuse gegenüberliegen. Die Sensorflächen 71 und 72 sind von einer gemeinsame Abschirmfläche 11 umrahmt, die sich zwischen den Sensorflächen 71, 72 entlang der Hypotenuse der Dreiecke erstreckt. Je nachdem an welcher Position relativ zu der lateralen Ausdehnung der Sensorflächen 71, 72 eine Betätigung durch den Benutzer erfolgt, indem der Benutzer die Blende 2 im Bereich der Sensorflächen 71, 72 und damit des Positionssensors berührt, ist aufgrund der Dreiecksform der Sensorflächen 71, 72 die Kapazität der mit den Sensorflächen 71, 72 gebildeten Kondensatoren unterschiedlich. Somit kann anhand der den Sensorflächen 71, 72 zugehörigen Ausgangssignale die Position der Betätigung bestimmt und damit ein dieser Position entsprechender bzw. zugeordneter Schaltzustand ausgelöst werden. Bei einer Änderung bzw. Verschiebung der Betätigungsposition, indem beispielsweise der Benutzer seinen Finger auf der Blende 2 verschiebt, wird diese Änderung ebenfalls detektiert und gegebenenfalls ein der neuen Position entsprechender Schaltzustand ausgelöst. Auf diese Weise bildet der Positionssensor einen Schiebeschalter ohne mechanisch zu verschiebende Elemente, durch den beispielsweise eine Temperatur oder eine Leistung bei einem Kochfeld, einem Klimagerät oder einem Kältegerät eingestellt werden kann.

In Figur 8 ist in einer schematischen Schnittansicht ein Ausschnitt des Eingabefeldes gemäß Figur 1 gezeigt. Auf der Leiterplatte 5 ist ein Lötring 7' aufgebrachte, mit dem der durch die unteren zwei Windungen der gewundenen Druckfeder 8 gebildete Windungsteller 9' mit der Leiterplatte 5 verlötet und auf diese Weise mit dem elektrischen Schaltkreis 14 verbunden ist. Die Druckfeder 8 umschließt mit ihren Windungen einen Hohlraum 34. Auf der Leiterplatte 5 sind innerhalb des Lötrings 7' auf der der Abdeckplatte 2 zugewandten Seite von den elektronischen Bauteilen des elektrischen Schaltkreises 14 der PNP-Bipolartransistor des Halbleiterschalters 18, mit seinem Basis-Emitter-Widerstand 23 und seinem Strombegrenzungswiderstand 20 sowie eine Leuchtdiode 35 angeordnet, die in den von der Druckfeder 8 umschlossenen Hohlraum 34 ragen. Um eine elektrische Verbindung dieser elektronischen Bauteile mit den weiteren Bauteilen des elektrischen Schaltkreises 14 zu ermöglichen, ist der Lötring 7' kein gänzlich geschlossener Ring, sondern seitlich unterbrochen (nicht gezeigt). Alternativ dazu kann die elektrische Verbindung auch durch die Leiterplatte 5 hindurch erfolgen. Zusammen mit der auf der Rückseite der Leiterplatte 5 angeordneten Abschirmfläche 11 bildet die Druckfeder 8 einen Faradaykäfig für die im Innenbereich 34 der Druckfeder 8 angeordneten elektronischen Bauteile, so dass diese gegenüber elektromagnetischen Feldern der Umgebung abgeschirmt sind.

### Bezugszeichenliste

- 1: Haushaltgerät
- 2: Blende
- 3: Eingabefeld
- 4: Annäherungsschalter
- 5: Leiterplatte
- 6: Rückseite der Blende
- 7: Sensorfläche
- 7': Lötring
- 8: Druckfeder
- 9: Windungsteller der oberen Windungen
- 9': Windungsteller der unteren Windungen
- 10: Referenzsensorfläche
- 11: Abschirmfläche
- 12: Elektronikmodul
- 13: Platine
- 14: Schaltkreis des Annäherungsschalters
- 15: Leistungselektronik
- 16: Finger des Benutzers
- 17: Kondensator
- 18: Halbleiterschalter
- 19: Steuereingang des Halbleiterschalters
- 20: Strombegrenzungswiderstand
- 21: Signaleingang des Halbleiterschalters
- 22: Signalausgang des Halbleiterschalters
- 23: Basis-Emitter-Widerstand
- 24: Sample and Hold-Stufe
- 25: Analoger Signalausgang des Mikroprozessors
- 26: Mikroprozessor
- 27: Analoger Signaleingang des Mikroprozessors
- 28: Taktsignal
- 29: Widerstand
- 30: Niederohmiger Widerstand
- 31: Schalter
- 32: Steuersignaleingang des Schalters
- 33: Steuersignalausgang des Mikroprozessors
- 34: von der Druckfeder umschlossener Hohlraum
- 35: Leuchtdiode

## Patentansprüche

1. Kapazitiver Annäherungsschalter, mit einer von einer elektrisch isolierenden Abdeckplatte (2) abgedeckten elektrisch leitenden Sensorfläche (7) als Teil eines Kondensators (17) mit durch Annäherung veränderlicher Kapazität, wobei die Sensorfläche (7) eine aktive Abschirmung aufweist, wobei die aktive Abschirmung durch eine Abschirmfläche (11) gebildet ist, an der zeitgleich mit der Sensorfläche (7) ein Taktsignal (28) anliegt, so dass zwischen der Sensorfläche (7) und der Abschirmfläche (11) kein Potenzialunterschied auftritt, **dadurch gekennzeichnet, dass** die Abschirmfläche (11) zur Funktionsprüfung des Annäherungsschalters (4) über einen Schalter (31) mit Masse verbindbar ist.

2. Annäherungsschalter nach Anspruch 1, **dadurch gekennzeichnet, dass** das Taktsignal (28) über einen niederohmigen Widerstand (30) an der Abschirmfläche (11) anliegt.

3. Annäherungsschalter nach Anspruch 1 oder 2, **dadurch gekennzeichnet, dass** der Schalter (31) einen Steuersignaleingang (32) aufweist, der mit einem Steuersignalausgang (33) eines Mikroprozessors (26) verbunden ist.

4. Annäherungsschalter nach einem der Ansprüche 1 bis 3, **dadurch gekennzeichnet, dass** der Schalter (31) ein Transistor ist.

5. Annäherungsschatter nach einem der Ansprüche 1 bis 4, **dadurch gekennzeichnet, dass** die Abschirmfläche (11) und die Sensorfläche (7) auf die Rückseite (6) der Abdeckplatte (2) aufgebracht sind, und dass die Abschirmfläche (11) die Sensorfläche (7) umgibt.

6. Annäherungsschalter nach einem der Ansprüche 1 bis 4, **dadurch gekennzeichnet, dass** die Abschirmfläche (11) und die Sensorfläche (7) auf der gleichen Seite eines Trägers (5) angeordnet sind, und dass die Abschirmfläche (11) die Sensorfläche (7) umgibt.

7. Annäherungsschalter nach einem der Ansprüche 1 bis 4, **dadurch gekennzeichnet, dass** die Sensorfläche (7) auf der Vorderseite eines Trägers (5) und die Abschirmfläche (11) auf der Rückseite des Trägers (5) zumindest im Bereich der Sensorfläche (7) angeordnet ist.

8. Annäherungsschalter nach Anspruch 6 oder 7, **dadurch gekennzeichnet, dass** der Träger (5) in einem Abstand von der Abdeckplatte (2) angeordnet ist, und dass zwischen Abdeckplatte (2) und Träger (5) ein elektrisch leitfähiger Körper (8) angeordnet ist, der den Abstand überbrückt und der mit der Sensorfläche (7) elektrisch leitend verbunden ist und/oder der zumindest mit einem Teil seiner Oberfläche zumindest einen Teil der Sensorfläche (7) bildet.

9. Annäherungsschalter nach Anspruch 6 oder 7, **dadurch gekennzeichnet, dass** der Träger (5) eine flexible Leiterplatte oder eine kupferkaschierte Kunststofffolie ist.

10. Annäherungsschalter nach Anspruch 8, **dadurch gekennzeichnet, dass** auf dem Träger (5) zumindest ein elektronisches Bauelement (18, 20, 23, 35) derart angeordnet ist, dass es in einen Hohlraum ragt, der von dem elektrisch leitfähigen Körper (8) umgeben ist.

11. Annäherungsschalter nach Anspruch 10, **dadurch gekennzeichnet, dass** das elektronische Bauelement der Halbleiterschalter (18, 20, 23) und/oder ein Leuchtelement (35) ist.

12. Annäherungsschalter nach Anspruch 10 oder 11, **dadurch gekennzeichnet, dass** der elektrisch leitfähige Körper (8) eine aus einem gestreckten Körper gewundene Druckfeder ist.

13. Eingabefeld für ein Haushaltgerät mit zumindest einem Annäherungsschalter (4) nach einem der Ansprüche 1 bis 12.

14. Eingabefeld nach Anspruch 13, **dadurch gekennzeichnet, dass** mehrere Sensorflächen (711, 712, 713, 721, 722, 723, 731, 732, 733) in einer Matrixform zum Betreiben in einem Multiplexverfahren geschaltet sind.

15. Eingabefeld nach Anspruch 13 oder 14, **dadurch gekennzeichnet, dass** zumindest zwei Sensorflächen (71, 72) benachbart angeordnet sind und zusammen einen Positionssensor bilden.

16. Haushaltgerät mit einem Eingabefeld nach einem der Ansprüche 13 bis 15.

## Claims

1. Capacitative proximity switch, with an electrically conductive sensor surface (7), which is covered by an electrically insulating cover plate (2), as part of a capacitor (17) with a capacitance variable by proximity, wherein the sensor surface (7) has an active screening, wherein the active screening is formed by a screening surface (11) to which a clock signal (28) is applied simultaneously with the sensor surface (7) so that no difference in potential arises between the sensor surface (7) and the screening surface (11), **characterised in that** the screening surface (11) is connectible with ground by way of a switch (31) for functional checking of the proximity switch (4).

2. Proximity switch according to claim 1, **characterised in that** the clock signal (28) is applied to the screening surface (11) by way of a low-impedance resistance (30).

3. Proximity switch according to claim 1 or 2, **characterised in that** the switch (31) has a control signal input (32) which is connected with a control signal output (33) of a microprocessor (26).

4. Proximity switch according to any one of claims 1 to 3, **characterised in that** the switch (31) is a transistor.

5. Proximity switch according to any one of claims 1 to 4, **characterised in that** the screening surface (11) and the sensor surface (7) are formed on the rear side (6) of the cover plate (2) and that the screening surface (11) surrounds the sensor surface (7).

6. Proximity switch according to any one of claims 1 to 4, **characterised in that** the screening surface (11) and the sensor surface (7) are arranged on the same side of a support (5) and that the screening surface (11) surrounds the sensor surface (7).

7. Proximity switch according to any one of claims 1 to 4, **characterised in that** the sensor surface (7) is arranged in the front side of a support (5) and the screening surface (11) on the rear side of the support (5) at least in the region of the sensor surface (7).

8. Proximity switch according to claim 6 or 7, **characterised in that** the support (5) is arranged at a spacing from the cover plate (2) and that arranged between cover plate (2) and support (5) is an electrically conductive body (8), which bridges over the spacing and which is electrically conductively connected with the sensor surface (7) and/or forms at least by a part of its surface at least a part of the sensor surface (7).

9. Proximity switch according to claim 6 or 7, **characterised in that** the support (5) is a flexible circuitboard or a copper-laminated plastics material film.

10. Proximity switch according to claim 8, **characterised in that** at least one electronic component (18, 20, 23, 35) is so arranged on the support (5) that it protrudes into a cavity which is surrounded by the electrically conductive body (8).

11. Proximity switch according to claim 10, **characterised in that** the electronic component is the semiconductor switch (18, 20, 23) and/or a lighting element (35).

12. Proximity switch according to claim 10 or 11, **characterised in that** the electrically conductive body (8) is a compression spring wound from a stretched body.

13. Input field for a domestic appliance with at least one proximity switch (4) according to any one of claims 1 to 12.

14. Input field according to claim 13, **characterised in that** several sensor surfaces (711, 712, 713, 721, 722, 723, 731, 732, 733) are connected in a matrix form for operation in a multiplex method.

15. Input field according to claim 13 or 14, **characterised in that** at least two sensor surfaces (71, 72) are arranged adjacently and together form a position sensor.

16. Domestic appliance with an input field according to any one of claims 13 to 15.

## Revendications

1. Détecteur de proximité capacitif doté d'une surface de capteur (7) électroconductrice en tant que partie d'un condensateur (17) à capacité changeante par approche, surface recouverte par une plaque de recouvrement (2) électriquement isolante, la surface de capteur (7) présentant un blindage actif, le blindage actif étant formé par une surface de blindage (11) sur laquelle un signal de rythme (28) est présent en même temps que sur la surface de capteur (7), de sorte qu'aucune différence de potentiel ne se produit entre la surface de capteur (7) et la surface de blindage (11), **caractérisé en ce que** la surface de blindage (11) est raccordable à la masse par l'intermédiaire d'un commutateur (31) pour le contrôle de fonctionnement du détecteur de proximité (4).

2. Détecteur de proximité selon la revendication 1, **caractérisé en ce que** le signal de rythme (28) est présent sur la surface de blindage (11) par l'intermédiaire d'une résistance (30) à faible résistance.

3. Détecteur de proximité selon la revendication 1 ou 2, **caractérisé en ce que** le commutateur (31) présente une entrée de signal de commande (32) qui est raccordée à une sortie de signal de commande (33) d'un microprocesseur (26).

4. Détecteur de proximité selon l'une quelconque des revendications 1 à 3, **caractérisé en ce que** le commutateur (31) est un transistor.

5. Détecteur de proximité selon l'une quelconque des revendications 1 à 4, **caractérisé en ce que** la surface de blindage (11) et la surface de capteur (7) sont appliquées au dos (6) de la plaque de recouvrement (2) et **en ce que** la surface de blindage (11) entoure la surface de capteur (7).

6. Détecteur de proximité selon l'une quelconque des revendications 1 à 4, **caractérisé en ce que** la surface de blindage (11) et la surface de capteur (7) sont disposées sur le même côté d'un support (5), et **en ce que** la surface de blindage (11) entoure la surface de capteur (7).

7. Détecteur de proximité selon l'une quelconque des revendications 1 à 4, **caractérisé en ce que** la surface de capteur (7) est disposée sur la face avant d'un support (5) et **en ce que** la surface de blindage (11) est disposée au dos du support (5) au moins dans la partie de la surface de capteur (7).

8. Détecteur de proximité selon la revendication 6 ou 7, **caractérisé en ce que** le support (5) est disposé à écart de la plaque de recouvrement (2) et **en ce qu'**un corps électroconductible (8) est disposé entre la plaque de recouvrement (2) et le support (5), ce corps surmontant l'écart et étant raccordé de manière électroconductrice à la surface de capteur (7) et/ou formant au moins une partie de la surface de capteur (7) au moins avec une partie de sa surface.

9. Détecteur de proximité selon la revendication 6 ou 7, **caractérisé en ce que** le support (5) est une plaquette flexible à circuit imprimé ou une feuille plastique cuivrée.

10. Détecteur de proximité selon la revendication 8, **caractérisé en ce qu'**au moins un composant électronique (18, 20, 23, 35) est disposé sur le support (5) de manière à ce qu'il dépasse dans un espace creux qui est entouré par le corps électroconducteur (8).

11. Détecteur de proximité selon la revendication 10, **caractérisé en ce que** le composant électronique est le commutateur à semi-conducteur (18, 20, 23) et/ou un élément électroluminescent (35).

12. Détecteur de proximité selon la revendication 10 ou 11, **caractérisé en ce que** le corps électroconducteur (8) est un ressort de compression tordu à partir d'un corps allongé.

13. Champ de saisie pour un appareil électroménager comprenant au moins un détecteur de proximité (4) selon l'une quelconque des revendications 1 à 12.

14. Champ de saisie selon la revendication 13, **caractérisé en ce que** plusieurs surfaces de capteur (711, 712, 713, 721, 722, 723, 731, 732, 733) sont connectées en forme de matrice pour le fonctionnement dans un procédé multiplex.

15. Champ de saisie selon la revendication 13 ou 14, **caractérisé en ce qu'**au moins deux surfaces de capteur (71, 72) sont disposées de manière avoisinante et forment ensemble un capteur de position.

16. Appareil ménager comprenant un champ de saisie selon l'une quelconque des revendications 13 à 15.
